# EUROPÄISCHE PATENTANMELDUNG

(11) **EP 1 705 970 A2**
(43) Veröffentlichungstag der Anmeldung: **27.09.2006**
(21) Anmeldenummer: 05112754.6
(22) Anmeldetag: 22.12.2005
(51) Int. Cl.: H05K 3/22, H05K 1/00

(54) **Verteiler mit Leiterplatte**

(30) Priorität: 17.03.2005 DE 202005004337 U
(71) Anmelder: Weidmüller Interface GmbH & Co. KG, 32758 Detmold (DE)
(72) Erfinder: Reker, Stefan, 33659, Bielefeld (DE)
(74) Vertreter: Dantz, Jan Henning

(57) **Zusammenfassung**

Ein Verteiler (1) umfasst ein Gehäuse (2), das eine Mehrzahl erster Anschlüsse für externe Feldgeräte wie Sensoren, Aktoren, Initiatoren und dgl. aufweist und wenigstens ein oder mehrere zweite Anschlüsse zum Anschluss des Verteilers z.B. an ein übergeordnetes Bussystem oder zur Verbindung des Verteilers mit weiteren Verteilern. Die ersten und zweiten Anschlüsse sind auf einer Leiterplatte (9) angeordnet und über eine elektrische Schaltung, die zumindest Leiterbahnen umfasst, leitend miteinander verbunden, wobei eine zwei Punkte (P1, P2) auf der Leiterplatte (9) leitend miteinander verbindende und mit einem Schneidwerkzeug wie einem Seitenscheider durchtrennbare leitende Brücke zwischen den Punkten (P1, P2) vorgesehen ist.

## Beschreibung

Die vorliegende Erfindung betrifft einen Verteiler nach dem Oberbegriff des Anspruchs 1.

Verteiler der vorerwähnten Art, deren bevorzugtes Einsatzgebiet die Automatisierungstechnik ist, wo sie in der Regel zum Anschluss von Feldgeräten wie Initiatoren, Aktoren, Sensoren oder dgl. dienen, sind an sich bekannt.

Die Verteiler weisen in der Regel mehrere erste Anschlüsse für die Feldgeräte und einen oder mehrere zweite Anschlüsse, die insbesondere zum Anschluss an ein übergeordnetes Bussystem dienen. Dabei sind auf einer Leiterplatte elektrische Leitungen und ggf. eine Elektronikschaltung zwischen den Anschlüssen für die Feldgeräte und den Anschlüssen für das überordnete Bussystem vorgesehen.

In der Regel werden die Verteiler einmalig fest installiert und nur im Störungsfall ausgetauscht. Sie weisen oftmals einen oder mehrere Umstecker (Jumper) auf, mit denen es möglich ist, die Leiterbahnanordnung auf der Leiterplatte je nach Einsatzzweck (z.B. Sensor oder Aktor) in der Regel einmalig bei der Installation voreinzustellen bzw. zwischen verschiedenen Zuständen umzuschalten.

Nachteilig an den Umschaltern, die sich an sich technisch bewährt haben, ist deren relativ hoher Preis, die insbesondere aus der Notwendigkeit resultieren, über die Umschalter relativ hohe Ströme fließen zu lasse.

Die Lösung dieses Problem ist die Aufgabe der Erfindung.

Die Erfindung löst diese Aufgabe durch den Gegenstand des Anspruchs 1.

Diese Lösung ist funktionssicher und sehr kostengünstig. Die Brücke ist z.B. als Drahtbrücke in U-Form sehr preiswert und wird einfach durchtrennt, wenn die leitende Verbindung nicht erforderlich ist. Zwar kann derart die leitende Verbindung nicht ohne weiteres wieder hergestellt werden. Dies ist aber auch in der Praxis auch fast nie erforderlich, da in der Regel einmalig bei der Erstinstallation z.B. an einer Maschine die Aufgabe jedes Verteilers definiert und dann später nicht wieder geändert wird. Es ist also möglich, durch den Einsatz der durchtrennbaren Brücke auf einfache Weise die Herstellkosten zu senken, da die relativ teueren Jumper durch eine einfache Brücke, insbesondere eine Drahtbrücke ersetzt werden können.

Vorteilhafte Ausgestaltungen sind in den Unteransprüchen angegeben.

Ein Ausführungsbeispiel der Erfindung ist in den beigefügten Zeichnungen dargestellt und wird im folgenden näher beschrieben.

Es zeigen:
- Figur 1: eine perspektivische Darstellung eines erfindungsgemäßen Verteilers;
- Figur 2: eine schematische Darstellung einer Umschalt-Drahtbrücke für den Verteiler aus Figur 1; und
- Figur 3: eine schematische Darstellung einer bekannten Umschalteinrichtung mit steckbaren Jumpern.

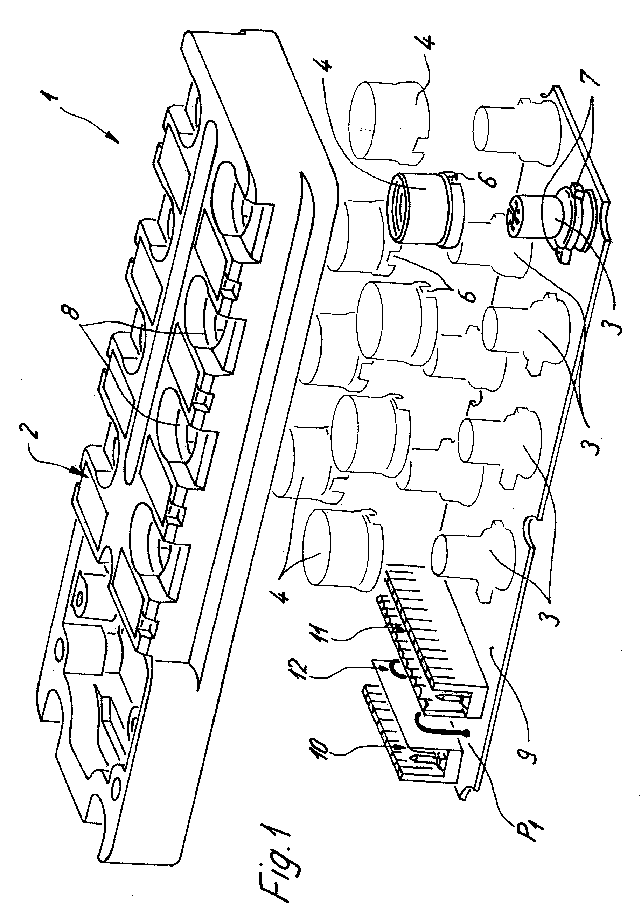

Fig. 1 zeigt einen Verteiler 1 für ein Feldbussystem, der zum Anschluss von Feldgeräten wie Initiatoren, Aktoren, Sensoren oder dgl. dient. Der Verteiler weist ein Gehäuse 2 sowie eine Vielzahl von Kontakteinsätzen 3 und die Kontakteinsätze 3 umgebenden Führungshülsen 4 aufweist, die als erste Anschlüsse zum Anschluss der Feldgeräte dienen.

Dabei sind die Führungshülsen 4 nach einer bevorzugten Ausgestaltung als separate, einstückige Bauteile aus Kunststoff hergestellt und im Kunststoff-Gehäuse 2 festgelegt, wobei zur Festlegung der Führungshülsen 4 im Kunststoff-Gehäuse 2 vorteilhafter Weise eine kraftschlüssige Verbindung gewählt ist, vorzugsweise ein Presssitz.

Um eine Verdrehsicherung zwischen der jeweiligen Führungshülse 4 und dem zugeordneten Kontakteinsatz 3 zu verwirklichen, ist jede Führungshülse 4 an einem stirnseitigen Ende mit in Achsrichtung verlaufenden Aussparungen 6 versehen, in welche radiale Ausleger 7 der jeweiligen Kontakteinsätze 3 formschlüssig eingreifen können. Die Führungshülsen 4 können innerhalb des Kunststoff-Gehäuses 2 statt über einen Presssitz auch stoff- oder formschlüssig festgelegt sein. Die Führungshülsen 4 durchtreten der Querschnittsfläche der Führungshülsen 4 entsprechende Durchbrechungen 8 des Kunststoff-Gehäuses 2.

Das Kunststoff-Gehäuse 2 einerseits und die Führungshülsen 4 andererseits sind aus Kunststoffen unterschiedlicher Materialeigenschaften hergestellt, so dass den Anforderungen, die an das Kunststoff-Gehäuse 2 sowie an die Führungshülsen 4 gestellt werden, ideal entsprochen werden kann.

Die Kontakteinsätze 3 können, wie Figur 1 andeutungsweise zeigt, auf einer Leiterplatte 9 befestigt sein, die mit dem Kunststoff-Gehäuse 2 auf übliche Weise verbindbar ist, beispielsweise durch Verschrauben.

Die Leiterplatte 9 ist mit einer elektrischen Schaltung versehen, die zumindest aus Leiterbahnen und ggf. elektrischen Bauelementen besteht. Dabei sind die Kontakteinsätze direkt oder über Bauelemente mit zwei Stiftleisten 10, 11 als zweiten Anschlüssen verbunden, die den Anschluss eines oder mehrer Kabel zu einem übergeordneten Feldbussystem und/oder zu weiteren Verteilern erlauben (hier nicht dargestellt).

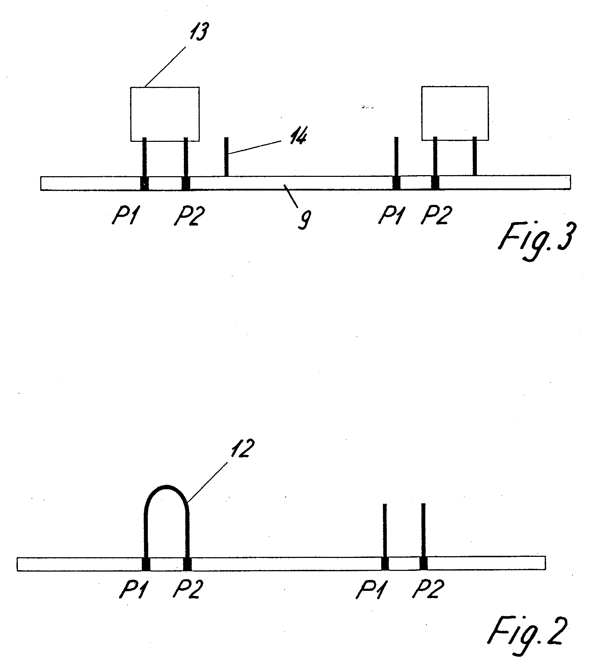

Da je nach Art der anzuschließenden Feldgeräte unterschiedliche leitende Verbindungen zwischen den Stiftleisten und den Kontakteinsätzen bzw. Anschlüssen für die Feldgeräte realisiert werden müssen, ist es nach dem Stand der Technik bekannt, die verschiedenen Leiterbahnwege über Jumper 13 voreinzustellen, die auf entsprechenden Stiften 14 umsetzbar sind (siehe Fig. 3).

Dabei ist es in der Regel lediglich notwendig, mit den Jumpern 13 eine leitende Verbindung zwischen zwei Punkten P1 und P2 auf der Leiterplatte 9 entweder zu schließen oder zu öffnen. Je nachdem, ob die Verbindung geöffnet oder geschlossen werden soll, wird der Jumper 13 in einer erste Position gesteckt, in der die leitende Verbindung zwischen den Punkten P1 und P2 geschlossen ist (linke Seite der Fig. 3)oder in eine zweite Position (rechte Seite der Fig. 3), in der Punkte P1 und P2 nicht leitend miteinander verbunden sind.

Demgegenüber geht die Neuerung einen anderen Weg. Sie macht sich zu Nutze, dass der Jumper in der "Parkposition" B quasi funktionslos ist und ersetzt die Umschalteinrichtung durch eine kostengünstige leitende Brücke, die derart ausgestaltet ist, dass sie auf der Leiterplatte 9 vorzugsweise mit einem Schneidwerkzeug wie einem Seitenschneider leicht durchtrennbar ist.

Ein Ausführungsbeispiel einer derartigen durchtrennbaren Brücke zeigt Fig. 3. Nach Fig. 3 ist die Brücke einfach als auf die Leiterplatte 9 aufgelötete U-förmige Drahtbrücke 12 ausgestaltet, welche die Punkte P 1 und P2 leitend miteinander verbindet (Fig. 2, linke Seite). Ist am Einsatzort ein Betriebszustand erforderlich, der keine leitende Verbindung zwischen den Punkten P1 und P2 erfordert, wird die Drahtbrücke 12 einfach durchtrennt oder es wird aus ihr ein ganzer Bereich herausgetrennt (Fig. 2, rechte Seite).

### Bezugszeichen

- Verteiler: 1
- Gehäuse: 2
- Kontakteinsätze: 3
- Führungshülsen: 4
- Aussparungen: 6
- Ausleger: 7
- Durchbrechungen: 8
- Leiterplatte: 9
- Stiftleisten: 10, 11
- Drahtbrücke: 12
- Jumper: 13
- Stiften: 14
- Punkten: P1 und P2

## Patentansprüche

1. Verteiler (1) mit einem Gehäuse (2), das eine Mehrzahl erster Anschlüsse für externe Feldgeräte wie Sensoren, Aktoren, Initiatoren und dgl. aufweist und wenigstens einen oder mehrere zweite Anschlüsse zum Anschluss des Verteilers z.B. an ein übergeordnetes Bussystem oder zur Verbindung des Verteilers mit weiteren Verteilern, wobei die ersten und zweiten Anschlüsse auf einer Leiterplatte (9) angeordnet und über eine elektrische Schaltung, die zumindest Leiterbahnen umfasst, leitend miteinander verbunden sind, **gekennzeichnet durch** eine zwei Punkte (P1, P2) auf der Leiterplatte (9) leitend miteinander verbindende und mit einem Schneidwerkzeug wie einem Seitenscheider durchtrennbare leitende Brücke zwischen den Punkten (P1, P2).

2. Verteiler nach Anspruch 1, **dadurch gekennzeichnet, dass** die leitende Brücke als Drahtbrücke (12) ausgestaltet ist, die an den zwei Punkten (P1, P2) an der Leiterplatte (9) befestigt ist.

3. Verteiler nach Anspruch 1 oder 2, **dadurch gekennzeichnet, dass** die Drahtbrücke (12) u-förmig ausgestaltet und rechtwinklig zur Leiterplatte ausgerichtet ist.
